(19) Europäisches Patentamt
European Patent Office
Office européen des brevets

(11) **EP 1 059 637 B1**

(12) **EUROPÄISCHE PATENTSCHRIFT**

(45) Veröffentlichungstag und Bekanntmachung des Hinweises auf die Patenterteilung:
**27.02.2008 Patentblatt 2008/09**

(21) Anmeldenummer: **00111728.2**

(22) Anmeldetag: **02.06.2000**

(51) Int Cl.:
*G11B 21/10* (2006.01)   *G11B 21/02* (2006.01)

(54) **Verfahren zur Erweiterung der Bandbreite von analog gespeicherten Sprachsignalen für ein Diktiergerät**

Method for extending the bandwidth of analog recorded speech signals for a dictation apparatus

Méthode pour l'extension de la bande passante de signaux vocaux enregistrés analogiquement pour un appareil de dictée

(84) Benannte Vertragsstaaten:
**AT BE CH CY DE DK ES FI FR GB GR IE IT LI LU MC NL PT SE**

(30) Priorität: **10.06.1999 DE 19926360**

(43) Veröffentlichungstag der Anmeldung:
**13.12.2000 Patentblatt 2000/50**

(73) Patentinhaber: **GBS Holding GmbH
85598 Baldham bei München (DE)**

(72) Erfinder: **Zhu, Ming, Dr.
90762 Fürth (DE)**

(74) Vertreter: **Pröll, Jürgen et al
Maryniok & Eichstädt
Anwaltssozietät
Kuhbergstrasse 23
96317 Kronach (DE)**

(56) Entgegenhaltungen:
**DE-A1- 4 434 255      DE-A1- 19 808 470
DE-C1- 4 214 053**

• **J. EPPS AND W. H. HOLMES: "SPEECH ENHANCEMENT USING STC-BASED BANDWIDTH EXTENSION" ICSLP, Dezember 1998 (1998-12), Seiten 711-714, XP007000515 Sydney, Australia**

**Beschreibung**

Die Erfindung betrifft ein Verfahren und ein Diktiergerät zur Aufzeichnung von Sprachsignalen, welches besonders geeignet ist um Sprachsignale einer späteren Sprachanalyse zuzuführen.

Diktiergeräte sind bereits bekannt und werden von vielen Firmen am Markt angeboten. Beispielsweise wurde ein Diktiergerät von der Firma Philips unter der Bezeichnung "390 POCKET MEMO" und von der Firma Grundig unter der Bezeichnung "Dh 2220" verkauft. Mittels dieser bekannten Diktiergeräte können vom Mikrofon aufgenommener Sprachsignale nach Verarbeitung in einer Aufzeichungsschaltung auf das Magnetband einer in das Diktiergerät eingelegten Diktierkassette aufgezeichnet werden. Weiterhin können mittels dieser bekannten Diktiergeräte auch die auf einer Diktiergerätekassette aufgezeichnete Signale nach Verarbeitung in eine Wiedergabeschaltung über den Lautsprecher des Diktiergerätes wiedergegeben und einer Kopfhörerausgangsbuchse zur Verfügung gestellt werden.

Infolge der fortschreitenden Entwicklung der Spracherkennungstechnologie gewinnt die automatische Diktattranskription eine zunehmende Bedeutung. Dies ist vor allem auf die rasante Steigerung der Rechenleistung von Personal-Computern zurückzuführen, wodurch die Realisierung von immer aufwendigeren Spracherkennungsalgorithmen ermöglicht wird.

Aus DE 4214053-A ist ein Diktiergerät mit einem Magnetbandspeicher und einem digitalen Speicher zur Speicherung von Sprachsignalen bekannt. Hierbei ist die Speicherkapazität des digitalen Speicher wesentlich geringer als die des Magnetbandspeicher. Mittels einer Korrektursteuereinrichtung und einer Markiereinrichtung wird die Vornahme von Korrekturen an beliebigen Textstellen ermöglicht, wobei der Text beim Einsprechen in das Mikrofon derart in Magnetbandspeicher aufgezeichnet und im digitalen Speicher gespeichert wird, daß synchron mit der Aufzeichnung im Magnetbandspeicher oder mit Wiedergabe von diesem im digitalen Speicher stets ein fortgeschriebenes digitales Korrekturdoppel bereitgestellt wird und mittels einer von Benutzer betätigtbaren Korrekturtaste in Verbindung mit der Korrektursteuereinrichtung und der Markiereinrichtung es ermöglicht wird, Textteile, sowohl des digitalen Speichers als auch des Magnetbandspeichers, zur Durchführung von Sprungfunktionen, Löschen und Verschieben zu nutzen.

Aus der nicht veröffentlichten Anmeldung DE 198 08 470.6 der Anmelderin ist ein Diktiergerät, welches ein Diktiergerätegehäuse aufweist, in welchem ein Mikrophon, ein Lautsprecher und eine Aufzeichnungs/Wiedergabesignalverarbeitungsschaltung vorgesehen ist, bekannt. Das Diktiergerätegehäuse ist mit einer Kopfhörer-Ausgangsbuchse versehen, an welcher während der Wiedergabe von auf einem Signalspeichermedium aufgezeichnete Signale ausgangsseitig zur Verfügung gestellt werden. Das Diktiergerätegehäuse ist mit einer weiteren Anschlußbuchse versehen, an welcher in einer ersten Betriebsart vom Mikrophon des Diktiergerätes abgeleitete Signale und in einer zweiten Betriebsart vom Signalspeichermedium abgeleitete Signale zur Verfügung gestellt werden.

Aus der DE 197 04 009 A ist ein Spracherkennungssystem zur Umsetzung eingespeister elektronischer Sprachsignale in zu elektronischen Datenverarbeitung geeigneten Signalen bekannt. Hierbei wird eine dem Spracherkennungssystem vorgeschaltete Pegelangleichvorrichtung zur Anpassung der Pegel der elektronischen Sprachsignale an eine vorbestimmte Bandbreite erreicht. Hierbei wird an die Pegelangleichvorrichtung wahlweise ein Mikrofon oder ein Tonträger-Abspielgerät angeschlossen.

Ausgehend von diesem Stand der Technik liegt der Erfindung die Aufgabe zu Grunde, ein Verfahren und ein Diktiergerät anzugeben, welches auf die Bedürfnisse einer weiteren Sprachverarbeitung eines von einem aufgezeichneten Diktates angepaßt ist und eine kostengünstige Speicherung der Sprachsignale ermöglicht.

Diese Aufgabe wird durch ein Verfahren mit den Merkmalen des Anspruches 1, sowie einem Diktiergerät mit den Merkmalen des Anspruches 5 gelöst.

Vorteilhafte Ausgestaltungen und Weiterbildungen der Erfindung ergeben sich aus den abhängigen Ansprüchen und der weiteren Beschreibung.

Das Verfahren nutzt insbesondere die technische Charakteristik von analogen Magnetbandkassetten und der bekannten magnetischen Aufzeichnungsverfahren von Diktiergeräten, wie aus dem Stand der Technik bekannt. Diese Diktiergeräte weisen eine Bandbreite von bis zu 4 kHz auf. Bei der Aufzeichnung wird das Sprachsignal faktisch einer Tiefpassfilterung unterzogen, hochfrequente Signalanteile gehen verloren. Diese Signalanteile sind aber für die weitere Verarbeitung im Spracherkennungssystem notwendig. Daher wird das über das Mikrofon aufgenommene Sprachsignal zunächst auf einem Bandspeichermedium gespeichert.

Es hat sich gezeigt, daß ein Spracherkennungssystem zur guten Weiterverarbeitung von Sprachsignalen eine Bandbreite des Sprachsignals von mindestens 8 bis 11 kHz erfordert. Dies ist aber durch eine Aufzeichnung auf ein Bandspeichermedium eines Diktiergerätes nicht ohne großen Aufwand, vor allem in Hinblick auf die Kosten, zu erfüllen. Eine komplette Digitalisierung und Speicherung des Diktats in digitaler Form erfordert eine hohen Speicherbedarf.

Daher wird das Sprachsignal zugleich über einen Hochpass geführt, wodurch die bereits auf dem Bandspeichermedium gespeicherten niederfrequenten Signalanteile ausgeblendet werden. Das hochfrequente Sprachsignal wird über einen Analog-Digital-Wandler digitalisiert, unter Berücksichtigung des Abtasttheorems. Die Abtastung erfolgt mit einer Abtastfrequenz von mehr als 22 kHz. Hierdurch werden die Anforderungen für eine spätere Spracherkennung erfüllt. Anschließend wird eine Datenkompression über die Mel-Skalierung durchgeführt, was zu einer Datenreduzierung führt.

Diese mel-skalierten Frequenbänder lassen sich analytisch mittels der Formel

$$z_c/\text{BARK} = 13 \arctan (0{,}76\, f/\text{kHz}) + 3{,}5 \arctan (f/7{,}5\, \text{kHz})^2$$

berechnen.

Die Grundlage dieser Funktion ist die Erkenntnis, daß der gesamte vom menschlichen Ohr aufnehmbare Frequenzbereich in eine Reihe von Frequenzgruppen aufgeteilt ist. Die Mittenfrequenz dieser Frequenzgruppen ist bis 1000 Hz annähernd linear, über 1000 Hz logarithmisch aufgeteilt. Diese Frequenzbänder können mit der obigen Funktion annäherungsweise aus den Bandraten $z_c$ in Bark errechnet werden. Hieraus ergibt sich, daß eine grobe Frequenzauflösung im höheren Frequenzbereich ausreicht um eine gute Merkmalsanalyse bei der Spracherkennung zu erhalten.

Anschließend wird das digitalisierte Sprachsignal komprimiert, um den Speicherbedarf weiter zu reduzieren. Zur verlustlosen Reduzierung der Daten hat sich insbesondere die Huffman-Kompression als besonders geeignet erwiesen.

Es erfolgt daher eine Gruppierung in Frequenzbereiche mit hoher Energie (niedere Frequenzbereiche) und in Frequenzbereiche mit niedriger Energie (hohe Frequenzbereiche). Durch eine stärkere Gruppierung der Frequenzbereiche mit hoher Energie, ist die zu erfassende Information in den Frequenzbereichen mit niedriger Energie geringer. Die niederfrequenten Frequenzbereiche werden auf das erste Speichermedium des Diktiergerätes aufgezeichnet. Wie oben bereits aufgeführt erfolgt hierdurch eine Tiefpaßfilterung mit einer Grenzfrequenz von 4 KHz. Die hochfrequenten Signalanteile werden, wie bereits beschrieben, über eine Hochpaßfilterung ermittelt und anschließend digitalisiert. Um keine Informationen zu verlieren wird die Hochpaßfilterung mit einer Grenzfrequenz durchgeführt, welche auf die Grenzfrequenz der Tiefpaßfilterung bei der Aufzeichnung der niederfrequenten Signalanteile auf dem Bandspeichermedium angepaßt ist.

Im digitalisierten Signal sind nunmehr die Informationen aus den hochfrequenten Signalanteilen enthalten. Diese haben, wie ausgeführt, einen geringeren Informationsgehalt für die Spracherkennung und können daher stark komprimiert werden, wobei die Mel-Skallierung berücksichtigt wird.

Das digitalisierte und komprimierte Sprachsignal muß, um es später wieder mit dem niederfrequenten Sprachsignal zusammen zu führen, auf das niederfrequente Sprachsignal synchronisiert werden. Hierzu werden Synchronisationssignale zusammen mit den komprimierten Sprachsignal in einen digitalen Speicher gespeichert.

Die Synchronisationssignale können auf verschiedene Weise gewonnen werden. Ein Weg hierzu ist, in das Sprachsignal vor der Aufzeichnung und Komprimierung ein Taktsignal einzustanzen, welches mit aufgezeichnet wird. Eine weitere Möglichkeit besteht darin, einen Zählerstand des Bandspeichermediums zur Aufzeichnung der niederfrequenten Signalanteile zu erfassen und zusammen mit dem hochfrequenten Signalanteilen abzuspeichern.

Bei der Wiedergabe der aufgezeichneten Sprachsignale und Eingabe in ein Spracherkennungssystem wird das im digitalisierte und komprimierte hochfrequente Sprachsignal dekomprimiert und analogisiert und grob auf das niederfrequente Sprachsignal synchronisiert und beide Signale einem Spracherkennungssystem zugeführt. Die Zuführung erfolgt in Form von zwei Sprachkanälen, wobei in einem Kanal das niederfrequente Sprachsignal und im anderen das hochfrequente Sprachsignal übertragen wird.

Eine weitere vorteilhafte Ausgestaltung des erfindungsgemäßen Verfahrens liegt darin, daß eine Dekomprimierung des hochfrequenten Sprachsignals entfällt. Das Spracherkennungssystem wird in der Weise modifiziert, daß die hochfrequenten Sprachsignalanteile in komprimierter Form weiterverarbeitet werden können. Diese werden lediglich vor der Übertragung an das Spracherkennungssystem analogisiert. Das niederfrequente Sprachsignal wird über einen der zwei Kanäle, insbesondere hat sich die Nutzung der Eingänge der Stereokanäle einer im Sprachverarbeitungssystem vorhandenen Soundkarte als vorteilhaft erwiesen, dem Spracherkennungssystem zugeführt, das hochfrequente komprimierte und auf das niederfrequente Sprachsignal synchronisierte Sprachsignal wird über den zweiten Stereokanal zugeführt. Das Spracherkennungssystem ist in der Lage aus beiden Signalanteilen eine Analyse der Sprache durchzuführen.

Eine Feinsynchronisation zwischen beiden Signalen wird durch eine Kreuzkorrelation erzeugt. Durch Kreuzkorrelation können beide Signale zueinander exakt synchronisiert werden.

Die Synchronisation beider Signale erfolgt vorteilhaft in zwei Schritten. Zunächst erfolgt eine Grobsynchronisation bei der Speicherung. Diese Grobsynchronisation erfolgt, indem beispielsweise die Daten eines Bandstandszähllaufwerkes des Bandspeichermediums des analogen Speichermediums zum hochfrequenten, digitalisierten und komprimierten Sprachsignal gespeichert werden. Aufgrund dieser Daten lassen sich beide Signale grob synchronisieren. Anschließend erfolgt eine Feinsynchronisation zwischen beiden Signalen durch eine Kreuzkorrelation.

Weitere vorteilhafte Eigenschaften der Erfindung ergeben sich aus der beispielhaften Erläuterung der Erfindung anhand von Figuren.

Es zeigt:

FIG 1    ein Blockschaltbild eines Diktiergerätes nach einem ersten Ausführungsbeispiel;

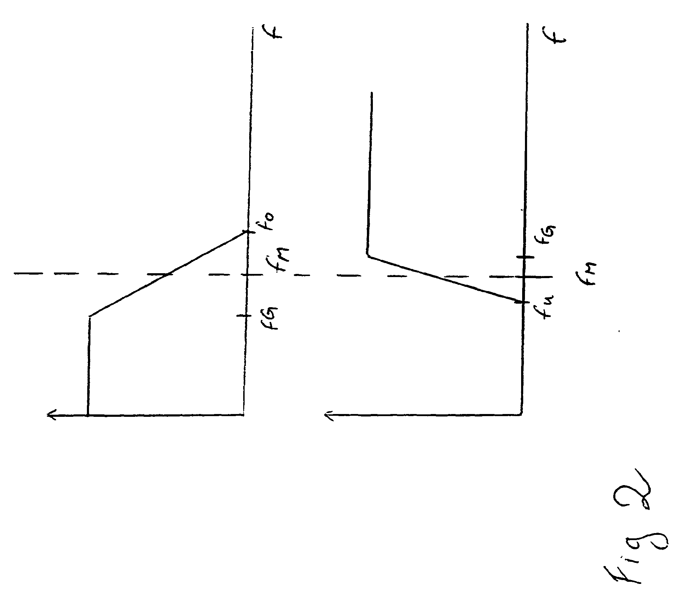

FIG 2    eine ausgewählte Charakteristik des Hochpaßfilters und des Tiefpaßfilter; und

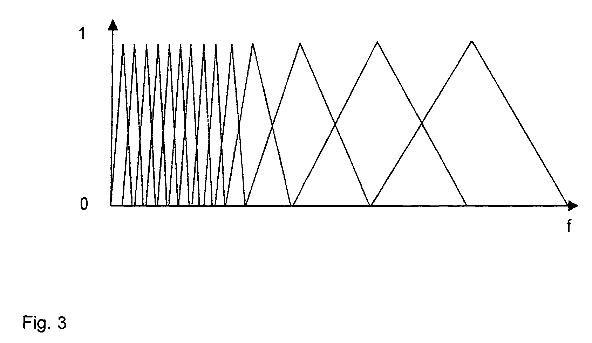

FIG 3    eine Skizze zur Veranschaulichung der durchzuführenden Mel-Skalierung.

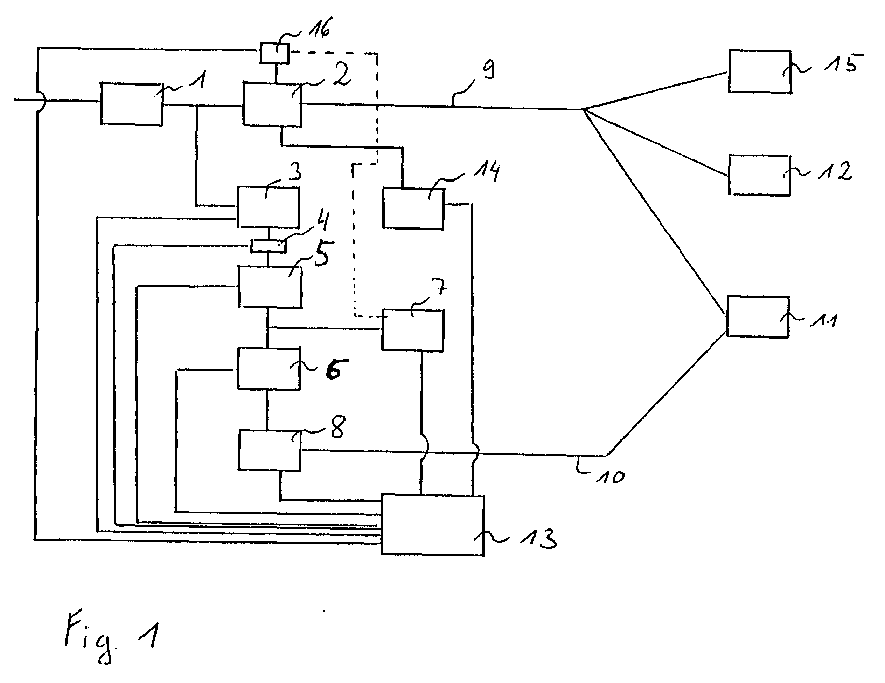

Die Figur 1 zeigt ein Blockschaltbild eines Diktiergerätes nach einem ersten Ausführungsbeispiel, bei welchem die Signale in analoger Form auf ein Magnetband einer Diktiergeräte-Kassette aufgezeichnet werden.

Das dargestellte Diktiergerät weist ein Mikrofon 1, einen analogen Bandspeicher 2, einen Hochpassfilter 3, einen Analog-Digital-Wandler 4, eine Kompressionseinheit 5, einen digitaler Speicher 6, eine Synchronisierungseinheit 7, einen Digital-Analog-Wandler 8, eine Mikroprozessoreinheit 13, eine Wiedergabeschaltung 14, einen Lautsprecher 15, ein Bandstandszählwerk 16, Leitungen 9 und 10, sowie eine 1-Kanal-Anschlußbuchse 12 und eine 2-Kanal-Anschlußbuchse 11 auf.

Mittels eines derartigen Diktiergerätes können vom Mikrofon 1 aufgenommene Signale nach einer aufzeichungsseitigen Signalverarbeitung auf den Magnetband des Bandspeichers 2, insbesondere einer Diktiergeräte-Kassette, aufgezeichnet werden. Weiterhin können mittels eines derartigen Diktiergerätes auf dem Magnetband des Bandspeichers 2 aufgezeichneten Signale nach einer wiedergabeseitigen Signalverarbeitung über einen Lautsprecher 15, welcher an die Leitung 9 angeschlossen ist, wieder gegeben werden. Zugleich können diese Signale an der 1-Kanalanschlußbuchse 12, insbesonderer einer Kopfhörerbuchse, welche ebenfalls mit der Leitung 9 verbunden ist, wiedergegeben werden.

Das über das Mikrofon 1 eingegebene Sprachsignal wird zeitgleich mit der Aufzeichnung auf dem Bandspeicher 2 über den Hochpaß 3 geführt. Hierdurch werden die niederfrequenten Signalanteile ausgefiltert. Anschließend steuert die Mikroprozessoreinheit 13 den Analog-Digital-Wandler 4 an, damit das hochpaßgefilterte Sprachsignal digitalisiert wird. Im weiteren Schritt wird, um Speicherplatz zu sparen, das digitalisierte Signal in der Kompressionseinheit 5 komprimiert. Die Komprimierung erfolgt ohne Datenverlust, insbesondere über eine Huffman-Kompression, unter Berücksichtigung der Mel-Skalierung. Hierdurch werden die Sprachsignale derart aufbereitet, daß selbige von einem nachgeschlateten Spracherkennungssystem optimal ausgewertet werden können, sofern dieses nach Mel-Skalierung die Merkmalsanalyse der Sprachsignale durchführt.

Die komprimierten Daten werden anschließend im digitalen Speicher 6 gespeichert. Vorteilhafter Weise ist der digitale Speicher 6 als Flashspeicher ausgestaltet. Bei der Wiedergabe muß jedoch der hochfrequente komprimierte Signalanteil des Sprachsignals zum analogen auf dem Bandspeicher 2 gespeicherten Signalanteil des Sprachsignal synchronisiert werden. Dies erfolgt über die Synchronisierungseinheit 7. Dieses Synchronisierungseinheit 7 stellt Signale bereit, mittels welcher die komprimierten und digitalisierten Sprachsignale auf das analoge gespeicherte Sprachsignal synchronisiert werden können. Ein einfacher Weg des Synchronisation liegt darin, das Bandstandszählwerk 16 des Bandspeichers 2 auszuwerten und als Synchronisationssignale zu verwenden. In einer weiteren vorteilhaften Ausgestaltung der Erfindung ist vorgesehen, die Synchronisation anhand der Bandlaufzeit zu ermitteln. Dieses wird von der Mikroprozessoreinheit 13 durchgeführt.

Bei der Wiedergabe der Sprachsignale zur weiteren Sprachanalyse muß das im Bandspeicher 2 gespeicherte Sprachsignal zum im digitalen Speicher 6 gespeicherten Sprachsignal synchronisiert sein. Dies erfolgt über die Synchronisierungseinheit 7, in oben beschriebener Weise. Das digitalisierte Sprachsignal aus dem digitalen Speicher 6 wird über den Digital-Analog-Wandler 8 in ein analog Signal umgesetzt und zum Sprachsignal aus dem Bandspeicher 2 synchronisiert. Das Sprachsignal aus dem Bandspeicher 2 wird über die Leitung 9 an den ersten Anschluß für den ersten Kanal der 2-Kanalanschlußbuchse 11 geleitet. Das hierzu synchronisierte hochfrequente Sprachsignal wird über die Leitung 10 an den Anschluß für den zweiten Kanal der 2-KanalAnschlußbuchse 11 geleitet. Über die Buchse 11 wird das Sprachsignal als 2-Kanalton (Stereosignal) an das Spracherkennungssystem geleitet. Auf dem ersten Kanal liegt das analoge niederfrequente Sprachsignal und auf dem zweiten Kanal liegt das hochfrequente Sprachsignal an.

In einer weiteren vorteilhaften Ausgestaltung der Erfindung ist der digitale Speicher 6 auf oder im Bandspeicher 2 integriert. Auf diese Weise kann ein Wechsel das Banspeichers 2 erfolgen, ohne daß die hochfrequenten Signalanteile und die Synchronisationsdaten verloren gehen.

Bezugszeichenliste

1    Mikrofon
2    erster Speicher

| 3 | Hochpaß |
|---|---|
| 4 | Analog-Digital-Umsetzer |
| 5 | Datenkompressionseinheit |
| 6 | zweiter Speicher |
| 7 | Synchronisierungseinheit |
| 8 | Digital-Analog-Umsetzer |
| 9 | Leitung |
| 10 | Leitung |
| 11 | 2-Kanal-Anschlußbuchse |
| 12 | 1-Kanal-Anschlußbuchse |
| 13 | Mikroprozessoreinheit |
| 14 | Wiedergabeschaltung |
| 15 | Lautsprecher |
| 16 | Bandstandszähler |

**Patentansprüche**

1. Verfahren zur Aufzeichnung und Wiedergabe eines Sprachsignals mittels eines Diktiergerätes zur späteren Spracherkennung in einem Spracherkennungssystem
wobei bei der Aufzeichnung
das Sprachsignal von einem Mikrofon aufgenommen wird, das Sprachsignal in einen niederfrequenten und einen hochfrequenten Anteil aufgespalten wird, der niederfrequente Anteil des Sprachsignals gespeichert wird, der hochfrequente Anteil des Sprachsignals digitalisiert wird, der hochfrequente digitalisierte Anteil des Sprachsignales komprimiert wird, dieser hochfrequente digitalisierte und komprimierte Anteil des Sprachsignales zum niederfrequenten Sprachsignal synchronisiert und gespeichert wird, und
bei der Wiedergabe
der gespeicherte hochfrequente digitalisierter und komprimierte Anteil des Sprachsignals in ein analoges Sprachsignal rückgewandelt wird und über die gespeicherten Synchronisationsdaten zum niederfrequenten analogen Sprachsignal exakt synchronisiert und einem Spracherkennungssystem zugeleitet wird.

2. Verfahren nach Anspruch 1,
**dadurch gekennzeichnet daß,**
das hochfrequente digitalisierte Sprachsignal über eine verlustlose Datenkompression, insbesondere eine Huffman Daten-Kompression, und unter Berücksichtigung der Mel-Skalierung, komprimiert wird.

3. Verfahren nach Anspruch 1 oder 2,
**dadurch gekennzeichnet, daß**
die Grobsynchronisation anhand von Daten, welche zusammen mit den niederfrequenten und dem hochfrequenten Datensignal gespeichert werden erfolgt.

4. Verfahren nach einem oder mehreren der vorangegangenen Ansprüche,
**dadurch gekennzeichnet daß**,
die Feinsychronisation zwischen dem niederfrequenten und dem hochfrequenten Sprachsignal über eine Kreuzkorrelation beider Signale erfolgt und/oder die Abtastung des hochfrequenten Sprachsignals mit mindestens 16 bis 22 kHz erfolgt.

5. Diktiergerät mit einer Mikroprozessoreinheit (13), einem Mikrofon (1), einem ersten Speicher (2), einem zweiten Speicher (6), einem Analog-Digital-Umsetzer (4), einem Digital-Analog-Umsetzer (8), einer 1-Kanal-Anschlußbuchse (12), einer 2-Kanal-Anschlußbuchse (11) und einem Lautsprecher (15), wobei das Mikrofon (1) Sprachsignale erfaßt und die Mikroprozessoreinheit (13) diese Sprachsignale in dem ersten Speicher (2) speichert,
**dadurch gekennzeichnet, daß**
die Mikroprozessoreinheit (13) dazu adaptiert ist, das Sprachsignal einem Hochpaßfilter (3) zu zuführen, das hochpassgefilterte Sprachsignal über den Analog-Digital-Umsetzer (8) zu digitalisieren und an die Kompressionseinheit (5) zu leiten, dass die Kompressionseinheit (5) dazu adaptiert ist, das digitalisierte Signal zu komprimieren der Mikroprozessor dazu adaptiert ist, (13) über die Synchronisierungseinheit (7) Synchronisierungsignale zum komprimierten Sprachsignal zu zufügen und im zweiten Speicher (6) zu speichern.

**6.** Diktiergerät nach Anspruch 5,
**dadurch gekennzeichnet, daß**
die Mikroprozessoreinheit (13) bei der Wiedergabe der gespeicherten Sprachsignale über den Lautsprecher (15) die im ersten Speicher (2) gespeicherten Sprachsignale über eine Wiedergabeschaltung (14) über die Leitung (9) an den Lautsprecher (15) leitet und/oder die Mikroprozessoreinheit (13) bei der Wiedergabe der gespeicherten Sprachsignale an die 1-Kanal-Anschlußbuchse (12) die im ersten Speicher (2) gespeicherten Sprachsignale über eine Wiedergabeschaltung (14) über die Leitung (9) an die 1-Kanal-Anschlußbuchse (12) leitet.

**7.** Diktiergerät nach Anspruch 5,
**dadurch gekennzeichnet, daß**
die Mikroprozessoreinheit (13) bei der Wiedergabe der gespeicherten Sprachsignale an eine Spracherkennungseinrichtung zur Sprache-in-Text-Umsetzung die im ersten Speicher (2) gespeicherten Sprachsignale über die Leitung (9) an die 2-Kanal-Anschlußbuchse (11) an deren ersten Anschluß leitet und die im zweiten Speicher (6) gespeicherten hochfrequenten digitalisierten und komprimierten Sprachsignale über den Digital-Analog-Umsetzer (8) in ein analoges Signal umwandelt und über die Leitung (10) an die 2-Kanal-Anschlußbuchse (11) an deren zweiten Anschluß leitet und die Mikroprozessoreinheit (13) beide Sprachsignale zueinander synchronisiert.

**8.** Diktiergerät nach einem der Ansprüche 5 bis 7,
**dadurch gekennzeichnet, daß**
der erste Speicher (2) ein analoger Bandspeicher ist und/oder der analoge Bandspeicher eine Diktiergeräte-Kassette ist und/oder der zweite Speicher (6) ein digitaler Speicher ist und/oder der digitale Speicher ein Flash-Speicher ist.

**9.** Diktiergerät nach einem der Ansprüche 5 bis 8,
**dadurch gekennzeichnet, daß**
der zweite Speicher (6) im und/oder am ersten Speicher (2) angeordnet ist.

**10.** Diktiergerät nach einem der Ansprüche 5 bis 9,
**dadurch gekennzeichnet, daß**
die Mikroprozessoreinheit (13) eine exakte Synchronisation beider gespeicherter Sprachsignale mittel einer Kreuzkorrelation durchführt und/oder am oder im Gehäuse der Diktiergeräte-Kassette ein digitaler Speicher, insbesondere ein Flash-Speicher, angeordnet ist.

**Claims**

**1.** Method of recording and reproducing a speech signal by means of a dictating machine for later speech recognition in a speech recognition system, wherein in the recording the speech signal is picked up by a microphone, the speech signal is split up into a low-frequency component and a high-frequency component, the low-frequency component of the speech signal is stored, the high-frequency component of the speech signal is digitalised, the high-frequency digitalised component of the speech signal is compressed, this high-frequency digitalised and compressed component of the speech signal is synchronised with the low-frequency speech signal and stored and in the reproduction the stored high-frequency digitalised and compressed component of the speech signal is converted back into an analog speech signal and is precisely synchronised by way of the stored synchronisation data with the low-frequency analog speech signal and conducted to a speech recognition system.

**2.** Method according to claim 1, **characterised in that** the high-frequency digitalised speech signal is compressed by way of a loss-free data compression, particularly a Huffman data compression, and with consideration of the Mel scaling.

**3.** Method according to claim 1 or 2, **characterised in that** the coarse synchronisation is carried out on the basis of data which are stored together with the low-frequency and the high-frequency data signal.

**4.** Method according to one or more of the preceding claims, **characterised in that** the fine synchronisation between the low-frequency and the high-frequency speech signal is carried out by a cross-correlation of the two signals and/or scanning of the high-frequency speech signal at at least 16 to 22 kHz.

**5.** Dictating machine with a microprocessor unit (13), a microphone (1), a first memory (2), a second memory (6), an analog-to-digital converter (4), a digital-to-analog converter (8), a 1-channel connecting sleeve (12), a 2-channel connecting sleeve (11) and a loudspeaker (15), wherein the microphone (1) detects speech signals and the microprocessor unit (13) stores the speech signals in the first memory (2), **characterised in that** the microprocessor unit (13) is adapted for the purpose of feeding the speech signal to a high-pass filter (3), digitalising the high-pass-filtered speech signal by way of the analog-to-digital converter and conducting it to the compression unit (5), that the compression unit (5) is adapted for the purpose of compressing the digitalised signal, and that the microprocessor (13) is adapted for the purpose of adding synchronisation signals to the compressed speech signal by way of the synchronisation unit (7) and storing them in the second memory (6).

6. Dictating machine according to claim 5, **characterised in that** the microprocessor unit (13) on reproduction of the stored speech signals by way of the loudspeaker (15) conducts the speech signals stored in the first memory (2) to the loudspeaker (15) via a reproducing circuit (14) by way of the line (9) and/or the microprocessor unit (13) on reproduction of the stored speech signals conducts to the 1-channel connecting sleeve (12) the speech signals, which are stored in the first memory (2), via a reproduction circuit (14) by way of the line (9) to the 1-channel connecting sleeve (12).

7. Dictating machine according to claim 5, **characterised in that** the microprocessor unit (13) on reproduction of the stored speech signals conducts to a speech recognition device for speech-into-text conversion the speech signals, which are stored in the first memory (2), via the line (9) to the 2-channel connecting sleeve (11) at the first connection thereof and converts the high-frequency digitalised and compressed speech signals, which are stored in the second memory (6), by way of the digital-to-analog converter (8) into an analog signal and conducts them by way of the line (10) to the 2-channel connecting sleeve (11) at the second connection thereof and the microprocessor unit (13) synchronises the two speech signals with one another.

8. Dictating machine according to one of claims 5 to 7, **characterised in that** the first memory (2) is an analog band memory and/or the analog band memory is a dictating machine cassette and/or the second memory (6) is a digital memory and/or the digital memory is a flash memory.

9. Dictating machine according to one of claims 5 to 8, **characterised in that** the second memory (6) is arranged in and/or at the first memory (2).

10. Dictating machine according to one of claims 5 to 9, **characterised in that** the microprocessor unit (13) carries out an exact synchronisation of the two stored speech signals by means of a cross correlation and/or a digital memory, particularly a flash memory, is arranged at or in the housing of the dictating machine cassette.

**Revendications**

1. Procédé pour enregistrer et reproduire un signal vocal au moyen d'un appareil de dictée à des fins de reconnaissance vocale ultérieure dans un système de reconnaissance vocale

   moyennant quoi, lors de l'enregistrement,
   le signal vocal est enregistré par un microphone, le signal vocal est divisé en une partie à basses fréquences et une partie à hautes fréquences, la partie à basses fréquences du signal vocal est mémorisée, la partie à hautes fréquences du signal vocal est numérisée, la partie à hautes fréquences numérisée du signal vocal est compressée, cette partie à hautes fréquences numérisée et compressée du signal vocal est synchronisée au signal vocal à basses fréquences et mémorisée,
   et lors de la reproduction
   la partie à hautes fréquences mémorisée, numérisée et comprimée du signal vocal est reconvertie en un signal vocal analogique et est synchronisée exactement avec le signal vocal analogique à basses fréquences au moyen des données de synchronisation mémorisées et est transmise à un système de reconnaissance vocale.

2. Procédé selon la revendication 1,
   **caractérisé en ce que**
   le signal vocal numérisé à hautes fréquences est compressé par une compression de données sans pertes, en particulier par une compression de données de Huffman, et en tenant compte de l'échelle de Mel.

3. Procédé selon la revendication 1 ou 2,
   **caractérisé en ce que**
   la synchronisation approximative se fait à l'aide de données qui sont mémorisées conjointement avec le signal de données à basses fréquences et avec le signal de données à hautes fréquences.

4. Procédé selon une ou plusieurs des revendications précédentes,
**caractérisé en ce que**
la synchronisation précise entre le signal vocal à basses fréquences et le signal vocal à hautes fréquences se fait par le biais d'une corrélation croisée des deux signaux et / ou l'échantillonnage du signal vocal à hautes fréquences se fait avec une fréquence d'au moins 16 à 22 kHz.

5. Appareil de dictée avec une unité de microprocesseur (13), un microphone (1), une première mémoire (2), une deuxième mémoire (6), un convertisseur analogique numérique (4), un convertisseur numérique analogique (8), une prise de raccordement à 1 canal (12), une prise de raccordement à 2 canaux (11) et un haut-parleur (15), moyennant quoi le microphone (1) capte des signaux vocaux et l'unité de microprocesseur (13) mémorise ces signaux vocaux dans la première mémoire (2),
**caractérisé en ce que**
l'unité de microprocesseur (13) est adaptée pour amener le signal vocal à un filtre passe-haut (3), pour numériser le signal vocal traité par le filtre passe-haut par le biais du convertisseur analogique numérique (8) et pour le transmettre à l'unité de compression (5), **en ce que** l'unité de compression (5) est adaptée pour compresser le signal numérisé, le microprocesseur (13) est adapté pour ajouter au signal vocal compressé des signaux de synchronisation par le biais de l'unité de synchronisation (7) et pour le mémoriser dans la deuxième mémoire (6).

6. Appareil de dictée selon la revendication 5,
**caractérisé en ce que**
l'unité de microprocesseur (13), lors de la reproduction par le biais du haut-parleur (15) des signaux vocaux mémorisés, amène les signaux vocaux, mémorisés dans la première mémoire (2), au haut-parleur (15) par le biais d'un circuit de reproduction (14) via la ligne (9) et / ou l'unité de microprocesseur (13), lors de la reproduction au niveau de la prise de raccordement à 1 canal (12) des signaux vocaux mémorisés, amène les signaux vocaux, mémorisés dans la première mémoire (2), par le biais d'un circuit de reproduction (14) via la ligne (9) à la prise de raccordement à 1 canal (12).

7. Appareil de dictée selon la revendication 5,
**caractérisé en ce que**
l'unité de microprocesseur (13), lors de la reproduction des signaux vocaux mémorisés au niveau d'un dispositif de reconnaissance vocale à des fins de conversion de la voix en un texte, amène les signaux vocaux mémorisés dans la première mémoire (2) via la ligne (9) allant à la prise de raccordement à 2 canaux (11) au premier raccordement de celle-ci et convertit les signaux vocaux à hautes fréquences numérisés et compressés mémorisés dans la deuxième mémoire (6) en un signal analogique par le biais du convertisseur numérique analogique (8) et les amène via la ligne (10) allant à la prise de raccordement à 2 canaux (11) au deuxième raccordement de celle-ci, et l'unité de microprocesseur (13) synchronise les deux signaux vocaux l'un par rapport à l'autre.

8. Appareil de dictée selon une des revendications 5 à 7,
**caractérisé en ce que**
la première mémoire (2) est un système analogique d'enregistrement à bande et / ou le système analogique d'enregistrement à bande est une cassette d'un appareil de dictée et / ou la deuxième mémoire (6) est une mémoire numérique et / ou la mémoire numérique est une mémoire flash.

9. Appareil de dictée selon une des revendications 5 à 8,
**caractérisé en ce que**
la deuxième mémoire (6) est disposée dans la première mémoire (2) et / ou au niveau de la première mémoire (2).

10. Appareil de dictée selon une des revendications 5 à 9,
**caractérisé en ce que**
l'unité de microprocesseur (13) exécute une synchronisation exacte des deux signaux vocaux mémorisés au moyen d'une corrélation croisée et / ou une mémoire numérique, en particulier une mémoire flash, est disposée dans ou au niveau du boîtier de la cassette de l'appareil de dictée.

Fig. 1

Fig 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4214053 A
- DE 19808470
- DE 19704009 A